# EUROPEAN PATENT SPECIFICATION

(11) **EP 0 317 133 B1**
(45) Date of publication and mention of the grant of the patent: **15.09.1993**
(21) Application number: 88310364.0
(22) Date of filing: 03.11.1988
(51) Int. Cl.: H01L 27/01, H01L 27/06

(54) **Semiconductor device for controlling supply voltage fluctuations**
Halbleitereinrichtung zur Kontrolle der Versorgungsspannungs-Fluktuationen
Dispositif semi-conducteur pour le contrôle de variation de tension d'alimentation

(30) Priority: 18.11.1987 JP 291114/87
(43) Date of publication of application: 24.05.1989
(73) Proprietor: Matsushita Electronics Corporation, Kadoma-shi, Osaka 571 (JP)
(72) Inventor: Nakano, Takeshi, Takatsuki-shi Osaka (JP)
(74) Representative: Crawford, Andrew Birkby

(56) References cited:
- US-A- 4 013 489
- US-A- 4 127 931
- IEEE TRANSACTIONS ON ELECTRON DEVICES, vol. ED-32, no. 2, February 1985, pages 242-247, IEEE, New York, US; A. CUTHBERTSON et al.: "Self-aligned transistors with polysilicon emitters for bipolar VLSI"
- PATENT ABSTRACTS OF JAPAN, vol. 11, no. 145 (E-505)[2592], 12th May 1987; & JP-A-61 283 154
- PATENT ABSTRACTS OF JAPAN, vol. 10, no. 248 (E-431)[2304], 26th August 1986; & JP-A-61 77 354

## Description

This invention relates to a semiconductor device possessing a PN junction capacity, in particular, a PN junction capacity capable of controlling the fluctuations of supply voltage.

Recently, as the semiconductor integrated circuit is increased in scale, lower power consumption and higher operating speed are desired. Accordingly, circuits operating to pass a large current only for the switching moment of the circuit device and not to pass otherwise are widely employed. When such circuits are used, the power supply current varies largely, which may adversely affect the circuit operation. Therefore, in a semiconductor device in which such circuits are fabricated, the supply voltage stabilizing means are necessary.

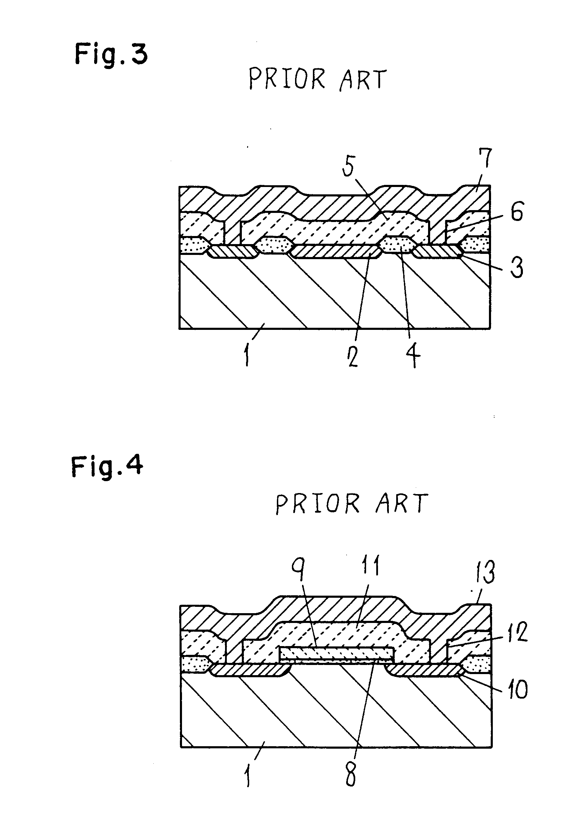

A conventional semiconductor device having stabilizing means of power source is explained below by referring to the sectional views in Figs. 3 and 4.

Fig. 3 is a sectional view of a semiconductor device in which the supply voltage is stabilized by using PN junction capacity. In Fig. 3, an N-type impurity diffusion region 2 and a P-type impurity diffusion region 3 are formed separately by an oxide film 4 for separation of device in a P-type silicon substrate 1, and the P-type impurity diffusion region 3 is connected with a wiring layer 7 of a grounding line through a contact hole 6 formed in an insulation film 5. On the other hand, the N-type impurity diffusion region 2 is connected with a wiring layer (not shown) of the power supply line formed on the insulation film 5 through a contact hole (not shown) provided in the insulation film 5 formed oblong in the direction orthogonal to the surface of the paper in Fig. 3.

In this constitution, since the P-type impurity diffusion region 3 and the P-type silicon substrate 1 are of the same conductive type, the PN junction formed between the N-type impurity diffusion region 2 connected to the wiring layer of the power supply line and the P-type silicon substrate 1 connected to the wiring layer 7 of the grounding line through the P-type impurity diffusion region 3 and contact hole 6 functions as a power supply capacity between the power supply line and the grounding line. Therefore, by means of such power supply capacity, the momentary current of the power line is absorbed, so that the potential fluctuations of the power supply line may be suppressed.

In the constitution shown in Fig. 3, however, the N-type impurity diffusion region is used as a wiring until it is connected with the wiring layer of the power supply line through the contact hole (not shown) formed in the insulation film 5. Accordingly, the wiring length becomes long, and its resistance functions as a resistor having a considerably large resistance connected in series to the power supply capacity between the power supply line and the grounding line. As a result, the time constant determined by the power supply capacity and the resistor increases, and the power supply capacity does not work effectively for stabilization of the supply voltage after the switching action of circuit elements.

Fig. 4 is a sectional view of a semiconductor device intended to stabilize the supply voltage by making use of a gate capacity. In Fig. 4, a gate oxide film 8 is formed on a P-type silicon substrate, and a gate polysilicon film 9 is formed on the gate oxide film 8. N-type impurity diffusion regions 10, 10 are formed at the right and left sides of the gate polysilicon film 9 during the same step of forming source and drain regions of field effect transistors (not shown). The N-type impurity diffusion region 10 is connected with a wiring layer 13 of a grounding line through a contact hole 12 formed in an insulation film 11. On the other hand, the gate polysilicon film 9 is formed along in a direction orthogonal to the surface of the paper in Fig. 4 and is connected with a wiring layer (not shown) of a power supply line formed on the insulation film 11 through a contact hole (not shown) formed in the insulation film 11. In this case, the gate capacity functions as a power supply capacity, and fluctuations of the supply voltage after switching action of circuit elements can be suppressed same as in the case of the prior art shown in Fig. 3.

In the case of Fig. 4, however, since the gate electrode of the MOS transistor is used as the power supply capacity, the breakdown voltage of the gate oxide film 8 is small, and the gate electrode is easily broken by the power supply surge.

JP-A-6177354 discloses a device which aims to reduce manufacturing cost by reducing by-pass capacitance. In this device a P⁺ type impurity-diffused region is formed in an N⁻ Si substrate, and an Si oxide layer is grown on its surface. A contact hole is formed in the Si oxide layer and a bonding pad (e.g. aluminum) is deposited to complete the production of the device. The bonding pad of this device is electrically connected to package leads by wire bonding. For example, V_{cc}(GND) may be impressed on the substrate, and V_{EE} (-5V) impressed on the pad. In this case, reverse bias is impressed on the P-N junction.

The present invention provides a semiconductor device comprising:
a semiconductor substrate of a first conductive type;
at least one first impurity diffusion region of a second conductive type formed in said semiconductor substrate;
a first power supply wiring layer adapted to be connected to a first terminal of a power supply and connected to said at least one first impurity diffusion layer;
characterised by further comprising:
at least one second impurity diffusion region of the first conductive type formed in said semiconductor substrate;
a second power supply wiring layer adapted to be connected to a second terminal of the power supply and connected to the semiconductor substrate through said at least one second impurity diffusion region; and
a conductive film formed on and connected to substantially the entire surface of said at least one first impurity diffusion region;
the first power supply wiring layer being connected to said at least one first impurity diffusion layer through said conductive film.

The present invention also provides a method of manufacturing a semiconductor device, comprising the steps of:
forming at least one first impurity diffusion region of a second conductive type in a semiconductor substrate of a first conductive type;
forming a first power supply wiring layer on said substrate adapted to be connected to a first terminal of a power supply and connected to said at least one first impurity diffusion layer;
characterised by further comprising;
forming at least one second impurity diffusion region of the first conductive type in the semiconductor substrate;
forming a second power supply wiring layer on said substrate adapted to be connected to a second terminal of the power supply and connected to said semiconductor substrate through said at least one second impurity diffusion region; and
forming a conductive film on substantially the entire surface of said at least one first impurity diffusion region and connected thereto;
the first power supply wiring layer being connected to said at least one first impurity diffusion layer through said conductive film.

A first advantage of this invention is the provision of a semiconductor device capable of effectively suppressing the power supply fluctuations after switching action of circuit elements, by minimizing the resistance element connected in series to the power supply capacity connected between power supply line and grounding line.

A second advantage of this invention is the provision of a semiconductor device capable of realizing a power supply capacity which can be hardly destroyed by a power supply surge.

In the constitution of the present invention, a power supply capacity composed of the semiconductor substrate and second impurity diffusion region is connected between the first and second power supply wiring layers, and the fluctuations of the supply voltage may be suppressed. Moreover, since a conductive film is formed on the surface of the second impurity diffusion region, the total resistance possessed by the conductive film and the second impurity diffusion region may be sufficiently lowered. Therefore, the resistance element connected in series to the power supply capacity is small, and the fluctuations of the supply voltage may be effectively suppressed. In addition, since the power supply capacity is composed of PN junction, it becomes stronger against surge unlike the structure of making use of the gate electrode of MOS transistor.

The features and other objects of the invention will be better understood and appreciated from the following detailed description taken in conjunction with the drawings.
Fig. 1 is a plan view of a semiconductor device in one of the embodiments of the present invention;
Fig. 2 is a sectional view of X-X' of Fig. 1;
Fig. 3 is a sectional view of a conventional semiconductor device; and
Fig. 4 is a sectional view of a different conventional semiconductor device.

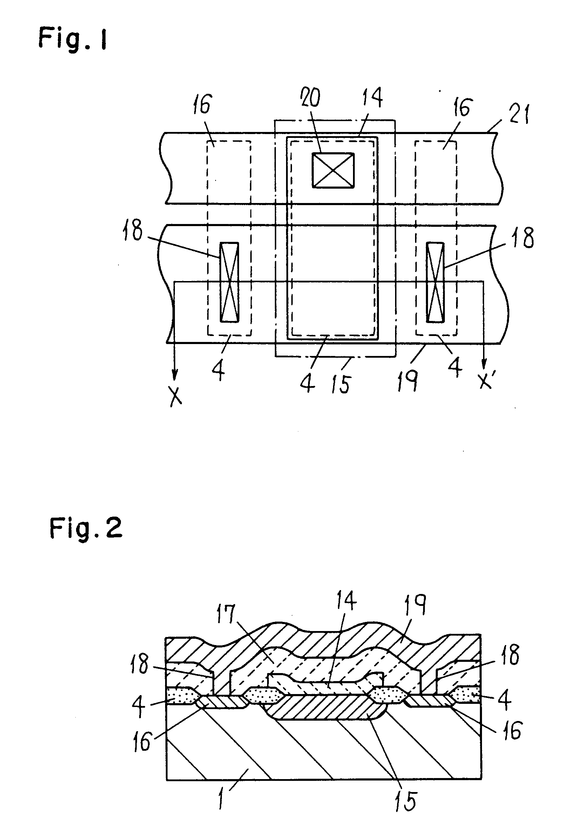

Fig. 1 is a plan view of a semiconductor device of an embodiment of this invention, and Fig. 2 is a sectional view of X-X' of Fig. 1.

Referring now to Figs. 1 and 2, an embodiment of the invention is described below.

In Figs. 1 and 2, an oxide film 4 for separation of element is selectively formed on the surface of a P-type silicon substrate 1, and a conductive film 14 containing an N-type impurity such as phosphorus (P) is formed on the surface of the P-type substrate 1 positioned between oxide films 4, 4 for separation of element. The conductive film 14 is composed of polysilicon, polycide or the like. By heat treatment, the N-type impurity contained in the conductive film 14 is diffused in the P-type silicon substrate 1. As a result, an N-type impurity diffusion region 15 is formed. On the other hand, at both sides of the N-type impurity diffusion region 15, P-type impurity diffusion regions 16, 16 are formed in the P-type silicon substrate 1. P-type impurity diffusion regions 16, 16 are separated by the oxide films 4, 4 for separation of element. The P-type impurity diffusion regions 16, 16 are connected to a wiring layer 19 of a grounding line formed on an insulation film 17 by way of contact holes 18, 18 formed in the insulation film 17. The conductive film 14 is, as shown in Fig. 1, formed in the outside region of the wiring layer 19 of the grounding line, and is connected to a wiring layer 21 of a power supply line provided parallel to the wiring layer 19 of the grounding line through a contact hole 20 formed in the insulation film 17.

In this way, P-type silicon substrate 1 is connected to the wiring layer 19 of the grounding line through the P-type impurity diffusion region 16 and the contact hole 18. On the other hand, the N-type impurity diffusion region 15 is connected to the wiring layer 21 of the power supply line through contact hole 20. As a result, the PN junction between the P-type silicon substrate 1 and the N-type impurity diffusion region 15 functions as a power supply capacity connected between the grounding line and power supply line.

In the composition in Figs. 1 and 2, the N-type impurity diffusion region 15 used as part of wiring has a certain length same as in the prior art as estimated from Fig. 1, but since the conductive film 14 of low resistance is formed on the entire surface of the N-type impurity diffusion region 15, the total resistance of the N-type impurity diffusion region 15 and conductive film 14 is considerably small. As a result, the resistance element connected in series to the power supply capacity formed by the N-type impurity diffusion region 15 and P-type silicon substrate 1 can be reduced. Hence, the time constant of the series resistance element and power supply capacity can be reduced, and the fluctuations of the supply voltage after switching action of circuit elements may be effectively suppressed by the power supply capacity. In particular, when the conductive film 14 is made of polycide, resistance value of the resistance element can be lowered by one digit. Besides, since PN junction is used as the power supply capacity, the power supply capacity is hardly destroyed by surge voltage, unlike the structure of using the gate electrode of MOS transistor shown in the prior art in Fig. 4.

## Claims

1. A semiconductor device comprising:
a semiconductor substrate (1) of a first conductive type;
at least one first impurity diffusion region (15) of a second conductive type formed in said semiconductor substrate (1);
a first power supply wiring layer (21) adapted to be connected to a first terminal of a power supply and connected to said at least one first impurity diffusion layer (15);
characterised by further comprising:
at least one second impurity diffusion region (16) of the first conductive type formed in said semiconductor substrate (1);
a second power supply wiring layer (19) adapted to be connected to a second terminal of the power supply and connected to the semiconductor substrate (1) through said at least one second impurity diffusion region (16); and
a conductive film (14) formed on and connected to substantially the entire surface of said at least one first impurity diffusion region (15);
the first power supply wiring layer (21) being connected to said at least one first impurity diffusion layer (15) through said conductive film (14).

2. A semiconductive device according to claim 1, wherein said first (15) and second (16) impurity diffusion regions extend in a first direction, and said first (21) and second (19) power supply wiring layers extend in a second direction orthogonal to said first direction.

3. A semiconductor device according to claim 1 or 2, wherein said conductive film (14) is polysilicon or polycide.

4. A method of manufacturing a semiconductor device, comprising the steps of:
forming at least one first impurity diffusion region (15) of a second conductive type in a semiconductor substrate (1) of a first conductive type;
forming a first power supply wiring layer (21) on said substrate adapted to be connected to a first terminal of a power supply and connected to said at least one first impurity diffusion layer (15);
characterised by further comprising;
forming at least one second impurity diffusion region (16) of the first conductive type in the semiconductor substrate (1);
forming a second power supply wiring layer (19) on said substrate adapted to be connected to a second terminal of the power supply and connected to said semiconductor substrate (1) through said at least one second impurity diffusion region (16); and
forming a conductive film (14) on substantially the entire surface of said at least one first impurity diffusion region (15) and connected thereto;
the first power supply wiring layer (21) being connected to said at least one first impurity diffusion layer (15) through said conductive film.

5. A method according to claim 4, wherein said first (15) and second (16) impurity diffusion regions are formed to extend in a first direction, and said first (21) and second (19) power supply wiring layers are formed to extend in a second direction orthogonal to said first direction.

6. A method according to claim 4 or 5, wherein the step of forming a conductive film (14) precedes the step of forming the at least one first impurity diffusion region (15), and the step of forming the at least one first impurity diffusion region (15) comprises diffusing an impurity of said second conductive type contained in said conductive film (14) into said semiconductor substrate (1).

7. A method according to claim 4 or 5, wherein said conductive film (14) is polysilicon or polycide.

## Patentansprüche

1. Eine Halbleitereinrichtung umfassend:
ein Halbleitersubstrat (1) eines ersten Leitfähigkeitstyps;
wenigstens einen ersten Störstellendiffusionsbereich (15) eines zweiten Leitfähigkeitstyps, der in dem genannten Halbleitersubstrat (1) gebildet ist;
eine erste Stromversorgungsverdrahtungsschicht (21), die geeignet ist, mit einem ersten Anschluß einer Stromversorgung verbunden zu werden und mit der genannten wenigstens einen Störstellendiffusionsschicht (15) verbunden ist;
dadurch gekennzeichnet, daß sie ferner umfaßt:
wenigstens einen zweiten Störstellendiffusionsbereich (16) vom ersten Leitfähigkeitstyp, der in dem genannten Halbleitersubstrat (1) gebildet ist;
eine zweite Stromversorgungsverdrahtungsschicht (19), die geeignet ist, mit einem zweiten Anschluß der Stromversorgung verbunden zu werden, und mit dem Halbleitersubstrat (1) durch den genannten wenigstens einen zweiten Störstellendiffusionsbereich (16) verbunden ist; und
eine leitende Schicht (14), die auf der im wesentlichen gesamten Oberfläche des genannten wenigstens einen ersten Störstellendiffusionsbereich (15) gebildet und mit diesem verbunden ist;
wobei die erste Stromversorgungsverdrahtungsschicht (21) mit der genannten wenigstens einen ersten Störstellendiffusionsschicht (15) durch die genannte leitende Schicht (14) verbunden ist.

2. Eine Halbleitereinrichtung gemäß Anspruch 1, in der sich der genannte erste (15) und zweite (16) Störstellendiffusionsbereich in einer ersten Richtung erstrecken und sich die erste (21) und die zweite (19) Stromversorgungsverdrahtungsschicht in einer zweiten Richtung senkrecht zu der genannten ersten Richtung erstrecken.

3. Eine Halbleitereinrichtung gemäß Anspruch 1 oder 2, in der die genannte leitende Schicht (14) Polysilizium oder eine Poly-Ladungsinjektionseinrichtung ist.

4. Ein Verfahren zum Herstellen einer Halbleitereinrichtung, das die Schritte umfaßt:
Bilden wenigstens eines ersten Störstellendiffusionsbereiches (15) eines zweiten Leitfähigkeitstyps in einem Halbleitersubstrat (1) eines ersten Leitfähigkeitstyps;
Bilden einer ersten Stromversorgungsverdrahtungsschicht (21) auf dem genannten Substrat, die geeignet ist, mit einem ersten Anschluß einer Stromversorgung verbunden zu werden und mit der genannten wenigstens einen Störstellendiffusionsschicht (15) verbunden ist;
dadurch gekennzeichnet, daß es ferner umfaßt;
Bilden wenigstens eines zweiten Störstellendiffusionsbereiches (16) des ersten Leitfähigkeitstyps in dem Halbleitersubstrat (1);
Bilden einer zweiten Stromversorgungsverdrahtungsschicht (19), die geeignet ist, mit einem zweiten Anschluß der Stromversorgung verbunden zu werden, und mit dem genannten Halbleitersubstrat (1) durch den genannten wenigstens einen zweiten Störstellendiffusionsbereich (16) verbunden ist; und
Bilden einer leitenden Schicht (14) auf der im wesentlichen gesamten Oberfläche des genannten wenigstens einen ersten Störstellendiffusionsbereiches (15) und verbunden mit diesem;
wobei die erste Stromversorgungsverdrahtungsschicht (21) mit der genannten wenigstens einen ersten Störstellendiffusionsschicht (15) durch die genannte leitende Schicht verbunden ist.

5. Ein Verfahren gemäß Anspruch 4, bei dem der genannte erste (15) und zweite (16) Störstellendiffusionsbereich so gebildet ist, daß er sich in einer ersten Richtung erstreckt, und die genannte erste (21) und zweite (19) Stromversorgungsverdrahtungsschicht so gebildet ist, daß sie sich in einer zweiten Richtung senkrecht zu der genannten ersten Richtung erstrecken.

6. Ein Verfahren gemäß Anspruch 4 oder 5, bei dem der Schritt des Bildens einer leitenden Schicht (14) dem Schritt des Bildens des wenigstens einen ersten Störstellendiffusionsbereiches (15) vorausgeht, und der Schritt des Bildens des wenigstens einen ersten Störstellendiffusionsbereiches (15) das Störstellendiffundieren des genannten zweiten Leitfähigkeitstyps, der in der genannten leitenden Schicht (14) enthalten ist, in das genannte Halbleitersubstrat (1) umfaßt.

7. Ein Verfahren gemäß Anspruch 4 oder 5, bei dem die genannte leitende Schicht (14) Polysilizium oder eine Poly-Ladungsinjektionseinrichtung ist.

## Revendications

1. Dispositif à semiconducteur, comprenant :
un substrat semiconducteur (1) d'un premier type de conductivité ;
au moins une première région de diffusion d'impureté (15), d'un deuxième type de conductivité, formée dans ledit substrat semiconducteur (1) ;
une première couche de câblage d'alimentation électrique (21) destinée à être connectée à une première borne d'une alimentation électrique et connectée à ladite première région de diffusion d'impureté (15) ;
caractérisé en ce qu'il comprend en outre :
au moins une deuxième région de diffusion d'impureté (16), du premier type de conductivité, formée dans ledit substrat semiconducteur (1) ;
une deuxième couche de câblage d'alimentation électrique (19) destinée à être connectée à une deuxième borne d'alimentation électrique et connectée au substrat semiconducteur (1) par l'intermédiaire de ladite deuxième région de diffusion d'impureté (16) ; et
une pellicule conductrice (14) formée sur sensiblement toute la surface de ladite première région de diffusion d'impureté (15) et connectée à celle-ci ;
la première couche de câblage d'alimentation électrique (21) étant connectée à ladite première région de diffusion d'impureté (15) par l'intermédiaire de ladite pellicule conductrice (14).

2. Dispositif à semiconducteur selon la revendication 1, où lesdites première et deuxième régions de diffusion d'impureté (15, 16) s'étendent suivant une première direction, et lesdites première et deuxième couches de câblage d'alimentation électrique (21, 19) s'étendent suivant une deuxième direction, perpendiculaire à ladite première direction.

3. Dispositif à semiconducteur selon la revendication 1 ou 2, où ladite pellicule semiconductrice (14) est faite de silicium polycristallin ou de polycide.

4. Procédé de fabrication d'un dispositif à semiconducteur, comprenant les opérations suivantes :
former au moins une région de diffusion d'impureté (15), d'un deuxième type de conductivité, dans un substrat semiconducteur (1) d'un premier type de conductivité ;
former une première couche de câblage d'alimentation électrique (21) sur ledit substrat, destinée à être connectée à une première borne d'une alimentation électrique et connectée à ladite région de diffusion d'impureté (15) ;
caractérisé en ce qu'il comprend en outre les opérations suivantes :
former au moins une deuxième région de diffusion d'impureté (16) du premier type de conductivité dans le substrat semiconducteur (1) ;
former une deuxième couche de câblage d'alimentation électrique (19) sur ledit substrat, destinée à être connectée à une deuxième borne de l'alimentation électrique et connectée audit substrat semiconducteur (1) par l'intermédiaire de ladite deuxième région de diffusion d'impureté (16) ; et
former une pellicule conductrice (14) sur sensiblement toute la surface de ladite première région de diffusion d'impureté (15) et la connecter à celle-ci ;
la première couche de câblage d'alimentation électrique (21) étant connectée à ladite première région de diffusion d'impureté (15) par l'intermédiaire de ladite couche conductrice.

5. Procédé selon la revendication 4, où on forme lesdites première et deuxième régions de diffusion d'impureté (15, 16) de façon qu'elles s'étendent suivant une première direction, et on forme lesdites première et deuxième couches de câblage d'alimentation électrique (21, 19) de façon qu'elles s'étendent suivant une deuxième direction, perpendiculaire à ladite première direction.

6. Procédé selon la revendication 4 ou 5, où l'opération de formation d'une pellicule conductrice (14) précède l'opération de formation de la première région de diffusion d'impureté (15), et l'opération de formation de la première région de diffusion d'impureté (15) consiste à faire diffuser une impureté dudit deuxième type de conductivité, contenue dans ladite pellicule conductrice (14), dans ledit substrat semiconducteur (1).

7. Procédé selon la revendication 4 ou 5, où ladite pellicule conductrice (14) est constituée de silicium polycristallin ou de polycide.
